# EUROPEAN PATENT APPLICATION

(11) **EP 4 221 251 A1**
(43) Date of publication of application: **02.08.2023**
(21) Application number: 21879143.2
(22) Date of filing: 01.09.2021
(51) Int. Cl.: H04R 1/10

(54) **EARPHONE**

(30) Priority: 16.10.2020 CN 202022311807 U
(71) Applicant: GUANGDONG OPPO MOBILE TELECOMMUNICATIONS CORP., LTD., Dongguan, Guangdong 523860 (CN)
(72) Inventor: SUN, Guozhen, Dongguan, Guangdong 523860 (CN)
(74) Representative: Ipside
(86) International application number: PCT/CN2021/116059
(87) International publication number: WO 2022/078097

(57) **Abstract**

An earphone is provided in implementations of the present disclosure. The earphone includes a first circuit board, a radio frequency (RF) transceiver, and an antenna. The first circuit board is provided with a first RF circuit. The RF transceiver is on the first circuit board. The RF transceiver is electrically connected with the first RF circuit. The first RF circuit is electrically connected with the antenna. The first circuit board has a reserved region. A surface acoustic wave (SAW) filter or a replacement resistor is disposed in the reserved region. The first RF circuit is electrically connected with the SAW filter or the replacement resistor 1000 which is disposed in the reserved region 10a. The reserved region is disposed on the first circuit board, whether to dispose the SAW filter or the replacement resistor in the reserved region is determined only according to requirements of a test result, and a via for the RF signal can be formed, such that a redesign for a layout of the first circuit board that has been designed is avoided, a design cycle shortened effectively, and design costs are reduced.

## Description

### CROSS-REFERENCE TO RELATED APPLICATIONS

This application claims priority to and the benefit of Chinese Patent Application No. 202022311807.0, filed October 16, 2020, the entire disclosure of which is hereby incorporated by reference.

### TECHNICAL FIELD

This disclosure relates to the field of electronic technology, and in particular to an earphone.

### BACKGROUND

Wireless earphones usually communicate with mobile phones, computers, and other devices through radio frequency (RF) technologies, and can realize functions of voice calling, music listening, etc. In the related art, whether a surface acoustic wave (SAW) filter needs to be additionally disposed on a circuit board is determined according to a test result of a RF signal of a wireless earphone. The SAW filter is used to filter out clutter in the RF signal. However, if the SAW filter has been designed during a design for a layout of the circuit board, but no SAW filter needs to be additionally disposed on the circuit board according to the test result of the RF signal, an existing circuit board needs to be redesigned. If no SAW filter has been designed during the design for the layout of the circuit board, but the SAW filter needs to be additionally disposed on the circuit board according to the test result of the RF signal, the existing circuit board also needs to be redesigned.

### SUMMARY

In view of this, an earphone is provided in implementations of the present disclosure. The earphone includes a first circuit board, a radio frequency (RF) transceiver, and an antenna. The first circuit board is provided with a first RF circuit. The RF transceiver is disposed on the first circuit board. The RF transceiver is electrically connected with the first RF circuit. The first RF circuit is electrically connected with the antenna. The first circuit board has a reserved region. A surface acoustic wave (SAW) filter or a replacement resistor is disposed in the reserved region. The first RF circuit is electrically connected with the SAW filter or the replacement resistor which is disposed in the reserved region.

### BRIEF DESCRIPTION OF THE DRAWINGS

FIG. 1 is a schematic structural view of an earphone provided in implementations of the present disclosure.
FIG. 2 is a schematic structural view of a structure illustrated in FIG. 1 from another perspective.
FIG. 3 is a schematic structural view of a structure illustrated in FIG. 1 from yet another perspective.
FIG. 4 is a schematic structural view of a first circuit board and a second circuit board provided in implementations of the present disclosure.
FIG. 5 is a schematic structural view of the first circuit board and the second circuit board in FIG. 4 from another perspective.
FIG. 6 is a partial enlarged schematic view of a first circuit board provided in implementations of the present disclosure.
FIG. 7 is another schematic structural view of a structure illustrated in FIG. 6, where a first layer is not illustrated.
FIG. 8 is another partial enlarged schematic view of a first circuit board provided in implementations of the present disclosure.
FIG. 9 is another schematic structural view of a structure illustrated in FIG. 8, where a sixth layer is not illustrated.
FIG. 10 is a partial enlarged schematic view of a second circuit board provided in implementations of the present disclosure.
FIG. 11 is another schematic structural view of a structure illustrated in FIG. 10, where a seventh layer is not illustrated.
FIG. 12 is another partial enlarged schematic view of a second circuit board provided in implementations of the present disclosure.
FIG. 13 is another schematic structural view of a structure illustrated in FIG. 12, where a twelfth layer is not illustrated.

### DETAILED DESCRIPTION

It should be noted that in case of no conflict, implementations and technical features in implementations of the present disclosure can be combined with each other. It should be understood that orientation terms in implementations of the present disclosure are only for convenience and simplification of description of the present disclosure, but do not indicate or imply that a device or element must have a specific orientation, be constructed and operated in a specific orientation, and therefore shall not be construed as a limitation to the present disclosure. The detailed description in the specific implementations should be understood as illustration of the purpose of the present disclosure and should not be regarded as an improper limitation to the present disclosure.

An earphone is provided in implementations of the present disclosure. The earphone has a circuit board that can be compatible with a surface acoustic wave (SAW) filter, such that a redesign for a layout of the circuit board is avoided. In order to realize the above beneficial effects, technical solutions of implementations of the present disclosure are realized as follows.

An earphone is provided in implementations of the present disclosure. The earphone includes a first circuit board, a radio frequency (RF) transceiver, and an antenna. The first circuit board is provided with a first RF circuit. The RF transceiver is disposed on the first circuit board. The RF transceiver is electrically connected with the first RF circuit. The first RF circuit is electrically connected with the antenna. The first circuit board has a reserved region, a SAW filter or a replacement resistor is disposed in the reserved region. The first RF circuit is electrically connected with the SAW filter or the replacement resistor which is disposed in the reserved region.

In some implementations, the earphone includes an in-ear portion, a rod portion, a second circuit board, and a connecting line. The first circuit board is disposed in the in-ear portion. The antenna is disposed in the rod portion. The second circuit board is disposed in the rod portion and provided with a second RF circuit. The connecting line electrically connects the first RF circuit with the second RF circuit. The connecting member electrically connects the antenna with the second RF circuit.

In some implementations, the earphone includes a first pi (π) filter on the first circuit board and a second π filter on the second circuit board. The first π filter is electrically connected with the SAW filter or the replacement resistor which is disposed in the reserved region. The second π filter is electrically connected with the second RF circuit.

In some implementations, the first circuit board includes a reserved bonding pad disposed in the reserved region. The replacement resistor includes at least two sub-resistors connected in series. One of the at least two sub-resistors is electrically connected with the first π filter, and another of the at least two sub-resistors is electrically connected with the reserved bonding pad.

In some implementations, the connecting line is a coaxial cable. The connecting line has a connecting terminal at each of two ends of the connecting line. The earphone includes a first coaxial-cable connector on the first circuit board and a second coaxial-cable connector on the second circuit board. The connecting terminal at one of the two ends of the connecting line is connected with the first coaxial-cable connector, and the connecting terminal at another of the two ends of the connecting line is connected with the second coaxial-cable connector. The first coaxial-cable connector is electrically connected with the first RF circuit. The second coaxial-cable connector is electrically connected with the second RF circuit.

In some implementations, the earphone includes a RF test pad on the first circuit board. The RF test pad is electrically connected with the first RF circuit.

In some implementations, the first circuit board includes a first layer, a second layer, and a third layer stacked in sequence. The first RF circuit includes a first signal line, a first shield, and a first reference line. The first signal line and the first shield each are on a surface of the first layer away from the second layer. The first reference line is on a surface of the third layer away from the second layer. A first shielding region is enclosed by the first shield. The first signal line and the first π filter each are in the first shielding region. The SAW filter electrically connected with the first π filter or the replacement resistor electrically connected with the first π filter is in the first shielding region. Part of the second layer is hollowed out to define a first hollowed-out region. A projection of the first signal line on the second layer, a projection of the first π filter on the second layer, and a projection of the SAW filter electrically connected with the first π filter or the replacement resistor electrically connected with the first π filter on the second layer each fall into the first hollowed-out region. The first circuit board defines in the first shield multiple first ground holes arranged at intervals.

In some implementations, the first circuit board includes a fourth layer, a fifth layer, and a sixth layer stacked in sequence. The first RF circuit includes a second signal line, a second shield, and a second reference line. The fourth layer is on the surface of the third layer away from the second layer. The second signal line, the second shield, the RF test pad, and the first coaxial-cable connector each are on a surface of the sixth layer away from the fifth layer. The second reference line is on a surface of the fourth layer away from the fifth layer. A second shielding region is enclosed by the second shield. Part of the fifth layer is hollowed out to define a second hollowed-out region. The second signal line, the RF test pad, and the first coaxial-cable connector each are in the second shielding region. A projection of the second signal line on the fifth layer, a projection of the RF test pad on the fifth layer, and a projection of the first coaxial-cable connector on the fifth layer each fall into the second hollowed-out region. The first circuit board defines in the second shield multiple second ground holes arranged at intervals.

In some implementations, the RF test pad and the first coaxial-cable connector each are on the surface of the first layer away from the second layer. The RF test pad and the first coaxial-cable connector each are in the first shielding region. A projection of the RF test pad on the second layer and a projection of the first coaxial-cable connector on the second layer each fall into the first hollowed-out region.

In some implementations, the second circuit board includes a seventh layer, an eighth layer, and a ninth layer stacked in sequence. The second RF circuit includes a third signal line, a third shield, and a third reference line. The third signal line, the third shield, the connecting member, and the second π filter each are on a surface of the seventh layer away from the eighth layer. The third reference line is on a surface of the ninth layer away from the eighth layer. A third shielding region is enclosed by the third shield. The third signal line, the second π filter, and the connecting member each are in the third shielding region. Part of the eighth layer is hollowed out to define a third hollowed-out region. A projection of the third signal line on the eighth layer, a projection of the connecting member on the eighth layer, and a projection of the second π filter on the eighth layer each fall into the third hollowed-out region. The second circuit board defines in the third shield multiple third ground holes arranged at intervals.

In some implementations, the second circuit board includes a tenth layer, an eleventh layer, and a twelfth layer stacked in sequence. The tenth layer is on the surface of the ninth layer away from the eighth layer. The second RF circuit includes a fourth signal line, a fourth shield, and a fourth reference line. Part of the eleventh layer is hollowed out to define a fourth hollowed-out region. The fourth signal line, the fourth shield, and the second coaxial-cable connector each are on a surface of the twelfth layer away from the eleventh layer. The fourth reference line is on a surface of the tenth layer away from the eleventh layer. A fourth shielding region is enclosed by the fourth shield. The fourth signal line and the second coaxial-cable connector each are in the fourth shielding region. A projection of the fourth signal line on the eleventh layer and a projection of the second coaxial-cable connector on the eleventh layer each fall into the fourth hollowed-out region. The second circuit board defines in the fourth shield multiple fourth ground holes arranged at intervals.

In some implementations, the second coaxial-cable connector is on the surface of the seventh layer away from the eighth layer. The second coaxial-cable connector is in the third shielding region. A projection of the second coaxial-cable connector on the eighth layer falls into the third hollowed-out region.

In some implementations, the connecting member is a spring lamination or a spring needle. The antenna is configured to abut against the connecting member at part of a surface of the antenna facing the connecting member; and/or the RF transceiver is a Bluetooth transceiver; and/or the RF transceiver is integrated on a system on a chip (SoC), and the SoC is on the first circuit board.

As for the earphone provided in implementations of the present disclosure, the reserved region is disposed on the first circuit board, whether to dispose the SAW filter or the replacement resistor in the reserved region is determined only according to requirements of a test result, and a via for the RF signal can be formed, such that a redesign for a layout of the first circuit board that has been designed is avoided, a design cycle shortened effectively, and design costs are reduced.

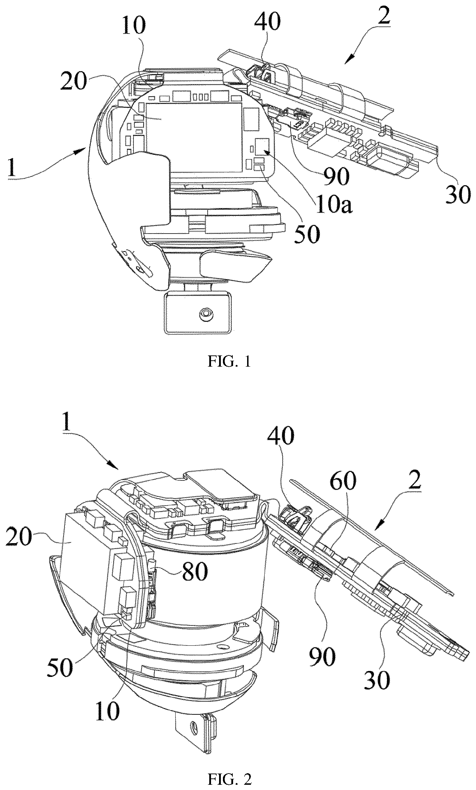

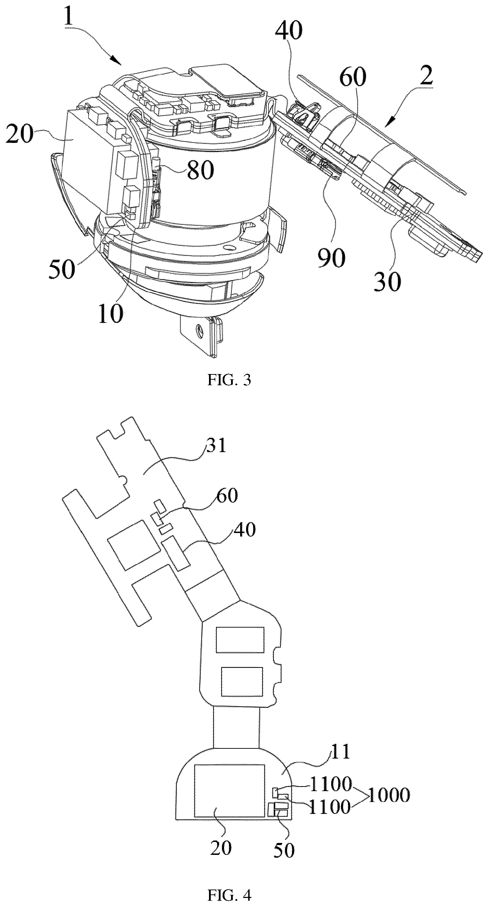

An earphone provided in implementations of the present disclosure are described in detail below. Reference can be made to FIG. 1 and FIG. 4. An earphone is provided in implementations of the present disclosure. The earphone includes a first circuit board 10, a RF transceiver 20, and an antenna. The first circuit board 10 is provided with a first RF circuit. The RF transceiver 20 is disposed on the first circuit board 10. The RF transceiver 20 is electrically connected with the first RF circuit. The first RF circuit is electrically connected with the antenna. The first circuit board 10 has a reserved region 10a. A SAW filter or a replacement resistor 1000 is disposed in the reserved region. The first RF circuit is electrically connected with the SAW filter or the replacement resistor 1000 which is disposed in the reserved region 10a.

The SAW filter is configured to filter out noise and/or a harmonic wave in a RF signal in order to maintain a good transmission quality of the RF signal. In the related art, whether the SAW filter needs to be additionally disposed is usually determined according to a subsequent debugging result. However, in this case, if the SAW filter has been designed in an original layout design for the first circuit board 10, but a test result indicates that the SAW filter is not needed, the original layout design for the first circuit board 10 needs to be modified; and vice versa, which is time-consuming and labor-intensive and has a long design cycle. In implementations of the present disclosure, the reserved region 10a is disposed on the first circuit board 10, whether to dispose the SAW filter or the replacement resistor 1000 in the reserved region 10a is determined only according to requirements of a test result, and a via for the RF signal can be formed, such that redesign for the layout of the first circuit board 10 that has been designed is avoided, a design cycle is shortened effectively, and design costs are reduced. Exemplarily, during actual debugging, if a performance of the RF signal is relatively good and no SAW filter is needed, the replacement resistor 1000 can be disposed in the reserved region 10a, and the RF signal passes through the replacement resistor 1000 during transmission. If the SAW filter needs to be additionally disposed to improve the transmission quality of the RF signal, the SAW filter can be disposed in the reserved region 10a, and the RF signal can be further filtered by the SAW filter during transmission.

In an implementation, reference can be made to FIG. 1~FIG. 3. The earphone includes an in-ear portion 1, a rod portion 2, a second circuit board 30, a connecting line, and a connecting member 40. The first circuit board 10 is disposed in the in-ear portion 1. The antenna is disposed in the rod portion 2. The second circuit board 30 is disposed in the rod portion 2. The second circuit board 30 is provided with a second RF circuit. The connecting line electrically connects the first RF circuit with the second RF circuit. The connecting member 40 electrically connects the antenna with the second RF circuit. The first RF circuit and the second RF circuit are connected with aid of the connecting line, such that the first circuit board 10 and the second circuit board 30 are connected with aid of the connecting line. The antenna and the second RF circuit of the second circuit board 30 are connected with aid of the connecting member 40. Therefore, the RF transceiver 20 can be disposed in the in-ear portion 1 and the antenna can be disposed in the rod portion 2, such that a RF link is formed by the RF transceiver 20, the first RF circuit, the connecting line, the second RF circuit, the connecting member 40, and the antenna. With this design, the RF transceiver 20 and the antenna can be flexibly disposed in an earphone with a relatively small size, such that a performance of the antenna is maximized.

In an implementation, reference can be made to FIG. 1-FIG. 4. The earphone includes a first π filter 50 on the first circuit board 10 and a second π filter 60 on the second circuit board 30. The first π filter 50 is electrically connected with the SAW filter or the replacement resistor 1000 which is disposed in the reserved region 10a. The second π filter 60 is electrically connected with the second RF circuit. The first π filter 50 and the second π filter 60 each are configured to filter out the noise and/or the harmonic signal in the RF signal. After the RF signal is filtered by the first π filter 50 and/or the second π filter, the transmission quality of the RF signal is improved. In some implementations, the first π filter 50 and the second π filter may filter together, or one of the first π filter 50 and the second π filter may filter according to requirements, and the other one of the first π filter 50 and the second π filter may play a standby role.

In a specific implementation, if the SAW filter is disposed in the reserved region 10a, the RF link may be formed by the RF transceiver 20, the first RF circuit, the first πfilter 50, the SAW filter, the connecting line, the second RF circuit, the second π filter, the connecting member 40, and the antenna. In another specific implementation, reference can be made to FIG. 4, and if the replacement resistor 1000 is disposed in the reserved region 10a, the RF link may be formed by the RF transceiver 20, the first RF circuit, the first π filter 50, the replacement resistor 1000, the connecting line, the second RF circuit, the second π filter, the connecting member 40, and the antenna.

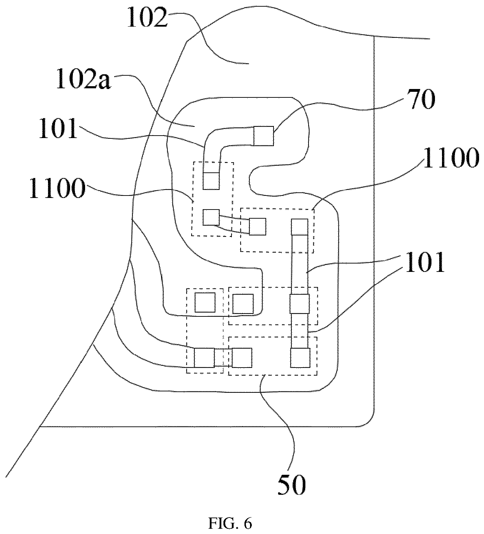

In an implementation, reference can be made to FIG. 6. For the convenience of illustrating a pad corresponding to the first π filter 50 and pads corresponding to sub-resistors 1100, the first π filter 50 and the sub-resistors 1100 are illustrated in FIG. 6 in dotted boxes. The first circuit board 10 includes a reserved bonding pad 70 disposed in the reserved region 10a. The replacement resistor 1000 includes at least two sub-resistors 1100 connected in series. One of the at least two sub-resistors 1100 is electrically connected with the first π filter 50, and the other one of the at least two sub-resistors 1100 is electrically connected with the reserved bonding pad 70. The reserved bonding pad 70 is configured for an electrical connection between the SAW filter or the replacement resistor 1000 and the first RF circuit. The reserved bonding pad 70 and the pad corresponding to the first π filter 50 are connected through a conductive line on the circuit board. For example, the reserved bonding pad 70 and a pad corresponding to a π filter can be connected through a first signal line 101, which will be described in detail. The conductive line (i.e., the first signal line 101) connecting the reserved bonding pad 70 and the pad corresponding to the first π filter 50 are prone to a stub (also known as a line end or a distorted line), and the stub may affect the transmission quality of the RF signal. Therefore, with aid of the at least two sub-resistors 1100 connected in series, the conductive line connecting the reserved bonding pad 70 and the pad corresponding to the first π filter 50 is reduced, thereby reducing the stub. Specifically, one of the two sub-resistors 1100 may be electrically connected with the first π filter 50 through the conductive wire, and the other one of the two sub-resistors 1100 may be electrically connected with the reserved bonding pad 70 through the conductive wire, or the pad corresponding to the other one of the two sub-resistors 1100 may be directly welded to the reserved bonding pad 70.

Exemplarily, a pad corresponding to a SAW filter commonly used has a size relatively close to a pad corresponding to a 01005 package resistor. The reserved bonding pad 70 has a size substantially the same as the pad corresponding to the SAW filter. The replacement resistor 1000 may include two 01005 package resistors. If no SAW filter is needed, when impedance matching in the RF link is met, one of the two 01005 package resistors is electrically connected with the reserved bonding pad 70, and the other one of the two 01005 package resistors is electrically connected with the first π filter 50.

In an implementation, reference can be made to FIG. 1~FIG. 3. The connecting line is a coaxial cable. The connecting line has a connecting terminal at each of two ends of the connecting line. The earphone includes a first coaxial-cable connector 80 on the first circuit board 10 and a second coaxial-cable connector 90 on the second circuit board 30. The connecting terminal at one end of the connecting line is connected with the first coaxial-cable connector 80, and the connecting terminal at the other end of the connecting line is connected with the second coaxial-cable connector 90. The first coaxial-cable connector 80 is electrically connected with the first RF circuit. The second coaxial-cable connector 90 is electrically connected with the second RF circuit.

On one hand, the connecting line is the coaxial cable, such that an external electromagnetic wave can be better prevented from interfering with transmission of the RF signal. The coaxial cable can also better realize the impedance matching with other electronic components or circuits in the RF link to ensure good transmission of the RF signal. On the other hand, operable space in the earphone is extremely small, and a size of the connecting line, a size of the first circuit board 10, and a size of the second circuit board 30 are also relatively small, such that the connection wire, the first circuit board 10, and the second circuit board 30 are not convenient to be assembled by welding and other processes. Therefore, the first coaxial-cable connector 80 is disposed on the first circuit board 10, the second coaxial-cable connector 90 is disposed on the second circuit board 30, and the connecting terminal is disposed at each of two ends of the coaxial cable. During assembling or disassembling, two connecting terminals are connected with the first coaxial-cable connector 80 and the second coaxial connector 90 respectively, such that welding does not need to be performed in limited operating space, which can realize quick assembly or disassembly, improve a manufacturing efficiency, facilitates maintenance, save layout space, and facilitate product miniaturization.

Exemplarily, one connecting terminal may be connected with the first coaxial-cable connector 80 by means of snap-in connection or threaded connection, and the other connecting terminal may be connected with the second coaxial-cable connector 90 by means of snap-in connection or threaded connection.

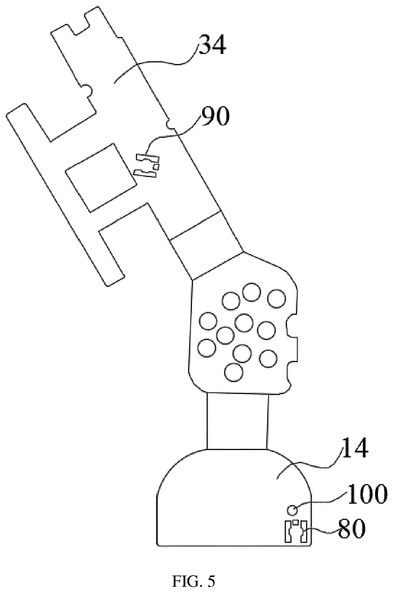

In an implementation, reference can be made to FIG. 5. The earphone includes a RF test pad 100 on the first circuit board 10. The RF test pad 100 is electrically connected with the first RF circuit. The RF test pad 100 is configured to test a performance of the RF link. Specifically, the RF test pad 100 is a conductive sheet. Generally, a RF test base is difficult to be disposed in the earphone with compact space, and compared with the RF test base, the RF test pad 100 has a simpler structure and is convenient to be disposed in the earphone with compact space. Preferably, part of a metal layer electrically connected with the first RF circuit may be reserved as the RF test pad 100 when green oil for solder mask is coated, such that less space is occupied by the RF test pad 100 and almost no device cost is needed.

In another implementation, the RF test pad 100 may be disposed on the second circuit board 30, and the RF test pad 100 is electrically connected with the second RF circuit.

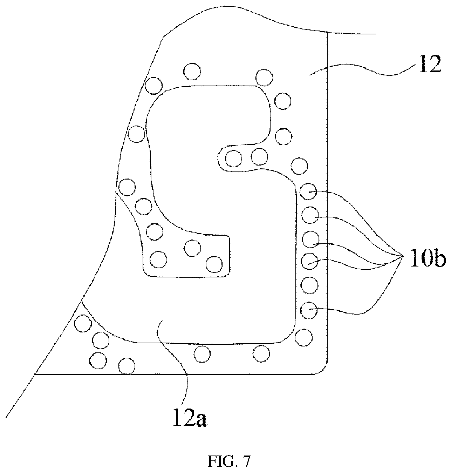

In an implementation, reference can be made to FIG. 4, FIG. 6, and FIG. 7. The first circuit board 10 includes a first layer 11, a second layer 12, and a third layer stacked in sequence. The first RF circuit includes a first signal line 101, a first shield 102, and a first reference line. The first signal line 101 and the first shield 102 each are on a surface of the first layer 11 away from the second layer 12. The first reference line is on a surface of the third layer away from the second layer 12. A first shielding region 102a is enclosed by the first shield 102. The first signal line 101 and the first π filter 50 each are in the first shielding region 102a. The SAW filter electrically connected with the first π filter 50 or the replacement resistor 1000 electrically connected with the first π filter 50 is in the first shielding region 102a. Part of the second layer 12 is hollowed out to define a first hollowed-out region 12a. A projection of the first signal line 101 on the second layer 12, a projection of the first π filter 50 on the second layer 12, and a projection of the SAW filter electrically connected with the first π filter 50 or the replacement resistor 1000 electrically connected with the first π filter 50 on the second layer 12 each fall into the first hollowed-out region 12a. The first circuit board 10 defines in the first shield 102 multiple first ground holes 10b arranged at intervals.

The first signal line 101 is a transmission path for the RF signal, the first reference line is a return path for the RF signal, part of the second layer 12 is hollowed out to define the first hollowed-out region 12a, and the first signal line 101 refers to the first reference line on the third layer, such that spacer-layer reference between the first signal line 101 and the first reference line is realized, a width of the first signal line 101 can be increased, and a conductor loss on the first circuit board 10 can be reduced, thereby realizing the impedance matching in the RF link. Preferably, the width of the first signal line 101 may be substantially the same as a width of a pad connected with the first signal line 101, such that phenomena such as an impedance shift, an impedance discontinuity, etc., on the transmission path for the RF signal can be avoided. Therefore, the transmission quality of the RF signal is ensured, and an energy loss of the RF link can be reduced. When the width of the first signal line 101 is relatively large, the first signal line 101 is less affected by an etching process, and product yield is higher. The projection of the first π filter 50 on the second layer 12 falls into the first hollowed-out region 12a, such that the size of the pad corresponding to the first π filter 50 is substantially the same as the width of the first signal line 101. The projection of the SAW filter electrically connected with the first π filter 50 or the replacement resistor 1000 electrically connected with the first π filter 50 on the second layer 12 falls into the first hollowed-out region 12a, such that the size of the pad corresponding to the SAW filter or the size of the pad corresponding to the replacement resistor 1000 is substantially the same as the width of the first signal line 101. The first shielding region 102a is enclosed by the first shield 102, the first signal line 101 and the first π filter 50 each are in the first shielding region 102a, and the SAW filter electrically connected with the first π filter 50 or the replacement resistor 1000 electrically connected with the first π filter 50 is in the first shielding region 102a. In other words, with aid of a coplanar impedance design, the return path for the RF signal is reduced by using the first shield 102, such that the width of the first signal line 101 can be prevented from being excessively large, the first signal line 101 can be prevented from occupying an excessive area of the first layer 11, and wiring on the first circuit board 10 can be more compact. With aid of the first ground holes 10b, the first shield 102 can better shield interference.

In an implementation, the first shield 102 may be a metal wire, for example, the first shield 102 may be a strip wire. In another implementation, the first shield 102 may be a metal layer, for example, the first shield 102 may be a copper sheet.

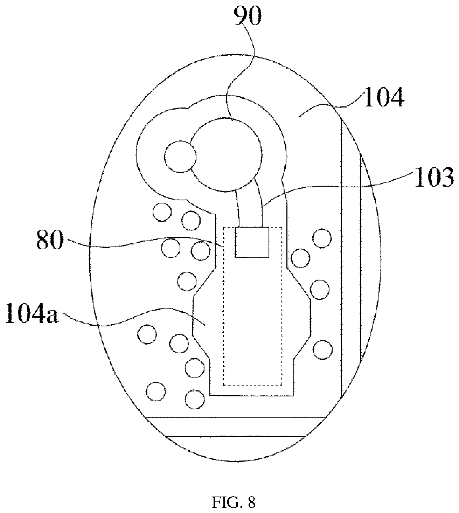

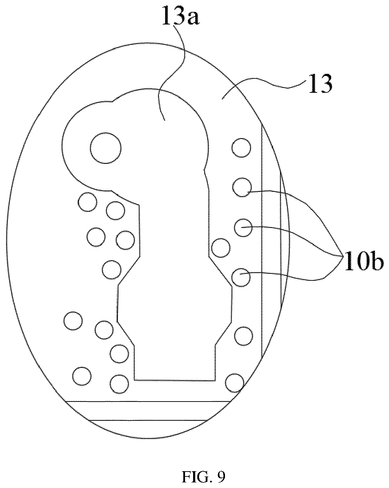

In an implementation, reference can be made to FIG. 5, FIG. 8, and FIG. 9. For the convenience of illustrating a pad corresponding to the first coaxial-cable connector 80, the first coaxial-cable connector 80 is illustrated in FIG. 8 in a dotted box. The first circuit board 10 includes a fourth layer, a fifth layer 13, and a sixth layer 14 stacked in sequence. The first RF circuit includes a second signal line 103, a second shield 104, and a second reference line. The fourth layer is on the surface of the third layer away from the second layer 12. The second signal line 103, the second shield 104, the RF test pad 100, and the first coaxial-cable connector 80 each are on a surface of the sixth layer 14 away from the fifth layer 13. The second reference line is on a surface of the fourth layer away from the fifth layer 13. A second shielding region 104a is enclosed by the second shield 104. Part of the fifth layer 13 is hollowed out to define a second hollowed-out region 13a. The second signal line 103, the RF test pad 100, and the first coaxial-cable connector 80 each are in the second shielding region 104a. A projection of the second signal line 103 on the fifth layer 13, a projection of the RF test pad 100 on the fifth layer 13, and a projection of the first coaxial-cable connector 80 on the fifth layer 13 each fall into the second hollowed-out region 13a. The first circuit board 10 defines in the second shield 104 multiple second ground holes 10c arranged at intervals.

Specifically, the second signal line 103 is electrically connected with the first signal line 101, and the first reference line is electrically connected with the second reference line. Exemplarily, the second signal line 103 may be electrically connected with the first signal line 101 through a via hole, and the first reference line may be electrically connected with the second reference line through a via hole. The second signal line 103 is a transmission path for the RF signal, the second reference line is a return path for the RF signal, part of the fifth layer 13 is hollowed out to define the second hollowed-out region 13a, and the second signal line 103 refers to the first reference line on the fourth layer, such that spacer-layer reference between the second signal line 103 and the second reference line is realized, a width of the second signal line 103 can be increased, and the conductor loss on the first circuit board 10 can be reduced, thereby realizing the impedance matching in the RF link. Preferably, the width of the second signal line 103 can be substantially the same as the width of a pad connected with the second signal line 103, such that the phenomena such as the impedance shift, the impedance discontinuity, etc., on the transmission path for the RF signal can be avoided. Therefore, the transmission quality of the RF signal is ensured, and the energy loss of the RF link can be reduced. When the width of the second signal line 103 is relatively large, the second signal line 103 is less affected by the etching process, and the product yield is higher. The projection of the RF test pad 100 on the fourth layer and the projection of the first coaxial-cable connector 80 on the fourth layer each fall into the second hollowed-out region 13a, such that the size of the pad corresponding to the first coaxial-cable connector 80 is substantially the same as the width of the second signal line 103. The second shielding region 104a is enclosed by the second shield 104, and the second signal line 103, the RF test pad 100, and the first coaxial-cable connector 80 each are in the second shielding region 104a. In other words, with aid of the coplanar impedance design, the return path for the RF signal is reduced by using the second shield 104, such that the width of the second signal line 103 can be prevented from being excessively large, the second signal line 103 can be prevented from occupying an excessive area of the sixth layer 14, and the wiring on the first circuit board 10 can be more compact. With aid of the second ground holes 10c, the second shield 104 can better shield the interference.

In an implementation, the second shield 104 may be a metal wire, for example, the second shield 104 may be a strip wire. In another implementation, the second shield 104 may be a metal layer, for example, the first shield 102 may be a copper sheet.

In an implementation, the RF test pad 100 and the first coaxial-cable connector 80 each are on the surface of the first layer 11 away from the second layer 12. The RF test pad 100 and the first coaxial-cable connector 80 each are in the first shielding region 102a. A projection of the RF test pad 100 on the second layer 12 and a projection of the first coaxial-cable connector 80 on the second layer 12 each fall into the first hollowed-out region 12a. In other words, the RF test pad 100, the first coaxial-cable connector 80, and the first π filter 50 each are on the surface of the first layer 11 away from the second layer 12, and the first signal line 101 is disposed between the RF test pad 100, the pad corresponding to the first coaxial-cable connector 80, and the pad corresponding to the first π filter 50, such that electrical connections between the above three electronic components can be realized.

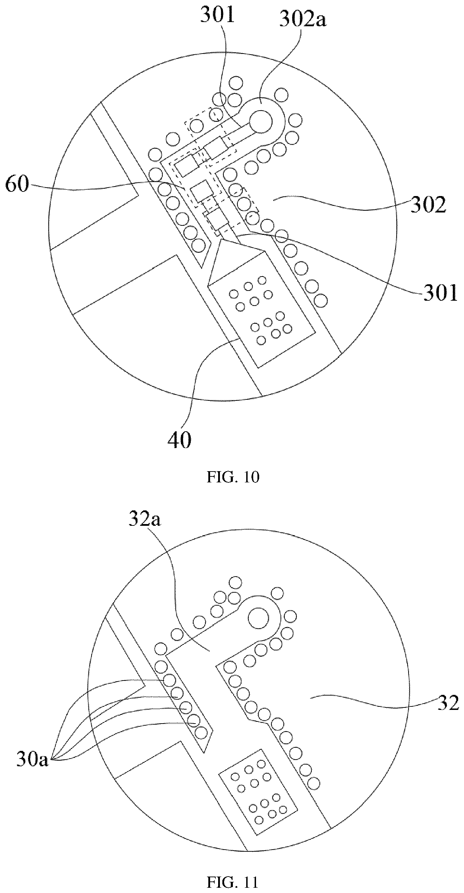

In an implementation, reference can be made to FIG. 4, FIG. 10, and FIG. 11. For the convenience of illustrating a pad corresponding to the second π filter 60, the second π filter 60 is illustrated in FIG. 10 in a dotted box. The second circuit board 30 includes a seventh layer 31, an eighth layer 32, and a ninth layer stacked in sequence. The second RF circuit includes a third signal line 301, a third shield 302, and a third reference line. The third signal line 301, the third shield 302, the connecting member 40, and the second π filter 60 each are on a surface of the seventh layer 31 away from the eighth layer 32. The third reference line is on a surface of the ninth layer away from the eighth layer 32. A third shielding region 302a is enclosed by the third shield 302. The third signal line 301, the second π filter 60, and the connecting member 40 each are in the third shielding region 302a. Part of the eighth layer 32 is hollowed out to define a third hollowed-out region 32a. A projection of the third signal line 301 on the eighth layer 32, a projection of the connecting member 40 on the eighth layer 32, and a projection of the second π filter 60 on the eighth layer 32 each fall into the third hollowed-out region 32a. The second circuit board 30 defines in the third shield 302 multiple third ground holes 30a arranged at intervals.

The third signal line 301 is a transmission path for the RF signal, the third reference line is a return path for the RF signal, part of the eighth layer 32 is hollowed out to define the third hollowed-out region 32a, and the third signal line 301 refers to the third reference line on the ninth layer, such that spacer-layer reference between the third signal line 301 and the third reference line is realized, a width of the third signal line 301 can be increased and a conductor loss on the second circuit board 30 can be reduced, thereby realizing the impedance matching in the RF link. Preferably, the width of the third signal line 301 may be substantially the same as a width of a pad connected to the third signal line 301, such that the phenomena such as the impedance shift, the impedance discontinuity, etc., on the transmission path for the RF signal can be avoided. Therefore, the transmission quality of the RF signal is ensured, the energy loss of the RF link can be reduced. When the width of the third signal line 301 is relatively large, the third signal line 301 is less affected by the etching process, and the product yield is higher. The projection of the connecting member 40 on the eighth layer 32 and the projection of the second π filter 60 on the eighth layer 32 each fall into the third hollowed-out region 32a, such that the size of the pad corresponding to the connecting member 40 and the size of the pad corresponding to the second π filter 60 each are substantially the same as the width of the third signal line 301. The third shielding region 302a is enclosed by the third shield 302, and the third signal line 301, the second π filter 60, and the connecting member 40 each in the third shielding region 302a. In other words, with aid of the coplanar impedance design, the return path for the RF signal is reduced by using the third shield 302, such that the width of the third signal line 301 can be prevented from being excessively large, the third signal line 301 is prevented from occupying an excessive area of the seventh layer 31, and the wiring on the second circuit board 30 can be more compact. With aid of the third ground holes 30a, the third shield 302 can better shield interference.

In an implementation, the third shield 302 may be a metal wire, for example, the third shield 302 may be a strip wire. In another implementation, the third shield 302 may be a metal layer, for example, the third shield 302 may be a copper sheet.

Specifically, the second π filter 60 is electrically connected with the connecting member 40 through the third signal line 301.

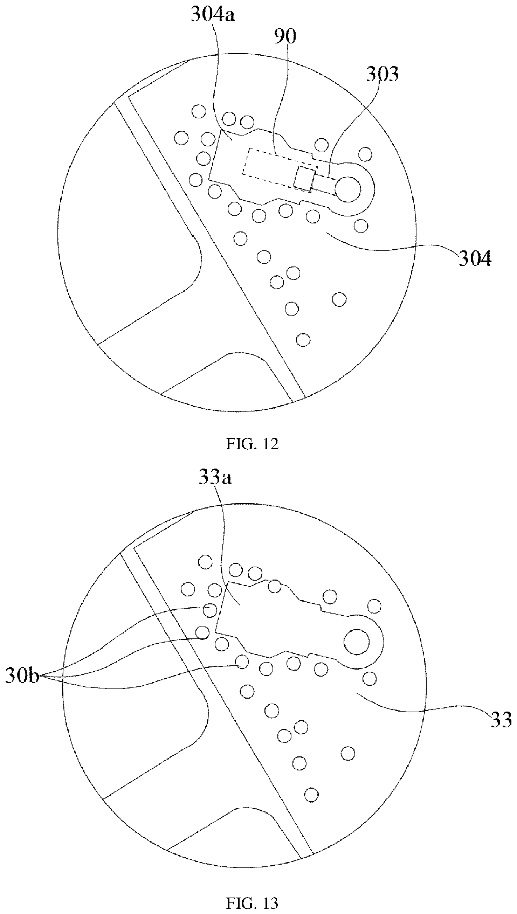

In an implementation, reference can be made to FIG. 5, FIG. 12, and FIG. 13. For the convenience of illustrating a pad corresponding to the second coaxial-cable connector 90, the second coaxial-cable connector 90 is illustrated in FIG. 12 in a dotted box. The second circuit board 30 includes a tenth layer, an eleventh layer 33, and a twelfth layer 34 stacked in sequence. The tenth layer is on the surface of the ninth layer away from the eighth layer 32. The second RF circuit includes a fourth signal line 303, a fourth shield 304, and a fourth reference line. Part of the eleventh layer 33 is hollowed out to define a fourth hollowed-out region 33a. The fourth signal line 303, the fourth shield 304, and the second coaxial-cable connector 90 each are on a surface of the twelfth layer 34 away from the eleventh layer 33. The fourth reference line is on a surface of the tenth layer away from the eleventh layer 33. A fourth shielding region 304a is enclosed by the fourth shield 304. The fourth signal line 303 and the second coaxial-cable connector 90 each are in the fourth shielding region 304a. A projection of the fourth signal line 303 on the eleventh layer 33 and a projection of the second coaxial-cable connector 90 on the eleventh layer 33 each fall into the fourth hollowed-out region 33a. The second circuit board 30 defines in the fourth shield 304 multiple fourth ground holes 30b arranged at intervals.

The fourth signal line 303 is a transmission path for the RF signal, the fourth reference line is a return path for the RF signal, part of the eleventh layer 33 is hollowed out to define the fourth hollowed-out region 33a, and the fourth signal line 303 refers to the fourth reference line on the tenth layer, such that spacer-layer reference between the fourth signal line 303 and the fourth reference line is realized, a width of the fourth signal line 303 can be increased and a conductor loss on the second circuit board 30 can be reduced, thereby realizing the impedance matching in the RF link. Preferably, the width of the fourth signal line 303 may be substantially the same as a width of a pad connected to the fourth signal line 303, such that the phenomena such as the impedance shift, the impedance discontinuity, etc., on the transmission path for the RF signal can be avoided. Therefore, the transmission quality of the RF signal is ensured, the energy loss of the RF link can be reduced. When the width of the fourth signal line 303 is relatively large, the fourth signal line 303 is less affected by the etching process, and the product yield is higher. The projection of the second coaxial-cable connector 90 on the eleventh layer 33 falls into the fourth hollowed-out region 33a, such that the size of the pad corresponding to the second coaxial-cable connector 90 is substantially the same as the width of the fourth signal line 303. The fourth shielding region 304a is enclosed by the third shield 302, and the fourth signal line 303 and the second coaxial-cable connector 90 each are in the fourth shielding region 304a. In other words, with aid of the coplanar impedance design, the return path of for RF signal is reduced by using the fourth shield 304, such that the width of the fourth signal line 303 can be prevented from being excessively large, the fourth signal line 303 can be prevented from occupying an excessive area of the twelfth layer 34, and the wiring on the second circuit board 30 can be more compact. With aid of the fourth ground holes 30b, the fourth shield 304 can better shield interference.

In an implementation, the second coaxial-cable connector 90 is on the surface of the seventh layer 31 away from the eighth layer 32, the second coaxial-cable connector 90 is in the third shielding region 302a, and the projection of the second coaxial-cable connector 90 on the eighth layer 32 falls into the third hollowed-out region 32a. In other words, the connecting member 40, the second coaxial-cable connector 90, and the second π filter 60 each are on the surface of the seventh layer 31 away from the eighth layer 32, and the third signal line 301 is disposed between the connecting member 40, the pad corresponding to the second coaxial-cable connector 90, and the pad corresponding to the second π filter 60, such that electrical connections between the above three electronic components can be realized.

In an implementation, reference can be made to FIG. 5, a projection of the RF test pad 100 on the first circuit board 10 is circular, and a circular RF test pad 100 has a diameter of 0.4mm~1.0mm. Exemplarily, the RF test pad 100 may have the diameter of 0.4mm, 0.5mm, 0.6mm, 0.7mm, 0.8mm, 0.9mm, 1.0mm, etc. The RF test pad 100 has a moderate size, which facilitates contact between a test probe and the RF test pad 100.

In other implementations, the projection of the RF test pad 100 on the first circuit board 10 may also be polygonal, elliptical, etc., and a polygon may be quadrangular, pentagonal, hexagonal, etc. The projection of the RF test pad 100 on the first circuit board 10 is not limited in shape.

In an implementation, reference can be made to FIG. 2. The connecting member 40 is a spring lamination or a spring needle, and the antenna is configured to abut against the connecting member 40 at part of a surface of the antenna facing the connecting member 40. In other words, by using restoring force of the spring lamination or the spring needle when elastic deformation is restored, the antenna can abut against the connecting member 40 at the part of the surface of the antenna facing the connecting member 40, such that a good electrical connection is maintained between the connecting member 40 and the antenna.

In an implementation, the RF transceiver 20 is a Bluetooth transceiver. In other words, a frequency band of the RF signal is 2400 to 2483.5 MHz. The earphone can perform Bluetooth pairing with other electronic devices through the antenna to realize signal transmission. Exemplarily, the earphone may perform Bluetooth pairing with one electronic device, or multiple electronic devices.

It should be noted that "multiple" in implementations of the present disclosure means two or more.

Usually, a set of earphones includes two earphones, one of the two earphones is used for a left ear and the other one of the two earphones is used for a right ear. The earphone in implementations of the present disclosure may be a wireless earphone. Exemplarily, the earphone in implementations of the present disclosure may be a true wireless stereo (TWS) earphone. For a set of TWS earphones, an earphone for the left ear and an earphone for the right ear can be paired with other devices through a RF signal (e.g., a Bluetooth signal), so as to transmit data through the RF signal (e.g., the Bluetooth signal).

In an implementation, reference can be made to FIG. 1. The RF Transceiver 20 is integrated on a SoC. Multiple functional modules such as a processor, a memory, etc., can be integrated on the SoC, and an integration level is relatively high. The processor can be configured to generate an electrical signal (e.g., a RF signal) and process a received electrical signal. The memory can be configured to store data. Therefore, the SoC is disposed on the first circuit board 10, such that accommodating space in the in-ear portion 1 can be fully utilized.

In some implementations, the earphone may generally further include other components. Exemplarily, the earphone includes a speaker in the in-ear portion 1. The in-ear portion 1 is generally partially accommodated in an ear to facilitate transmission of a sound wave to the ear by the speaker in the in-ear portion 1. In some implementations, the earphone may further include a battery. The battery can be configured to supply power to the first circuit board 10, the second circuit board 30, and electronic components on the first circuit board 10 and the second circuit board 30. The battery may be a rechargeable battery. The earphone may include contact points for contacting an external charger, and the contact points contact the external charger to charge the battery of the earphone. Exemplarily, the external charger may be a charging case for the earphone. In some implementations, the earphone may further include a microphone. The microphone can be configured to collect the sound wave, such that the user can perform voice communication.

The foregoing implementations are merely some implementations of the present disclosure The protection scope of the present disclosure is not limited thereto. Those skilled in the art can easily think of modifications or substitutions within the technical scope disclosed in the present disclosure, and these modifications or substitutions shall be fall in the scope of protection of the present disclosure. Therefore, the protection scope of the present disclosure shall be subject to the protection scope of the claims.

## Claims

1. An earphone, comprising:
a first circuit board, a radio frequency (RF) transceiver, and an antenna, wherein the first circuit board is provided with a first RF circuit, and the RF transceiver is disposed on the first circuit board, the RF transceiver is electrically connected with the first RF circuit, and the first RF circuit is electrically connected with the antenna, wherein
the first circuit board has a reserved region, a surface acoustic wave (SAW) filter or a replacement resistor is disposed in the reserved region, the first RF circuit is electrically connected with the SAW filter or the replacement resistor which is disposed in the reserved region.

2. The earphone of claim 1, comprising:
an in-ear portion, wherein the first circuit board is disposed in the in-ear portion;
a rod portion, wherein the antenna is disposed in the rod portion;
a second circuit board disposed in the rod portion and provided with a second RF circuit;
a connecting line electrically connecting the first RF circuit with the second RF circuit; and
a connecting member electrically connecting the antenna with the second RF circuit.

3. The earphone of claim 2, comprising a first pi (π) filter on the first circuit board and a second π filter on the second circuit board, wherein the first π filter is electrically connected with the SAW filter or the replacement resistor which is disposed in the reserved region, and the second π filter is electrically connected with the second RF circuit.

4. The earphone of claim 3, wherein the first circuit board comprises a reserved bonding pad disposed in the reserved region, the replacement resistor comprises at least two sub-resistors connected in series, wherein one of the at least two sub-resistors is electrically connected with the first π filter, and another of the at least two sub-resistors is electrically connected with the reserved bonding pad.

5. The earphone of claim 3, wherein the connecting line is a coaxial cable, the connecting line has two connecting terminals at two ends of the connecting line respectively, the earphone comprises a first coaxial-cable connector on the first circuit board and a second coaxial-cable connector on the second circuit board, wherein one connecting terminal of the connecting line is connected with the first coaxial-cable connector, another connecting terminal of the connecting line is connected with the second coaxial-cable connector, the first coaxial-cable connector is electrically connected with the first RF circuit, the second coaxial-cable connector is electrically connected with the second RF circuit.

6. The earphone of claim 5, comprising a RF test pad on the first circuit board, wherein the RF test pad is electrically connected with the first RF circuit.

7. The earphone of claim 6, wherein the first circuit board comprises a first layer, a second layer, and a third layer stacked in sequence, the first RF circuit comprises a first signal line, a first shield, and a first reference line, the first signal line and the first shield each are on a surface of the first layer away from the second layer, the first reference line is on a surface of the third layer away from the second layer, a first shielding region is enclosed by the first shield, the first signal line and the first π filter each are in the first shielding region, the SAW filter electrically connected with the first π filter or the replacement resistor electrically connected with the first π filter is in the first shielding region, part of the second layer is hollowed out to define a first hollowed-out region, a projection of the first signal line on the second layer, a projection of the first π filter on the second layer, and a projection of the SAW filter electrically connected with the first π filter or the replacement resistor electrically connected with the first π filter on the second layer each fall into the first hollowed-out region, and the first circuit board defines in the first shield a plurality of first ground holes arranged at intervals.

8. The earphone of claim 7, wherein the first circuit board comprises a fourth layer, a fifth layer, and a sixth layer stacked in sequence, the first RF circuit comprises a second signal line, a second shield, and a second reference line, the fourth layer is on the surface of the third layer away from the second layer, the second signal line, the second shield, the RF test pad, and the first coaxial-cable connector each are on a surface of the sixth layer away from the fifth layer, the second reference line is on a surface of the fourth layer away from the fifth layer, a second shielding region is enclosed by the second shield, part of the fifth layer is hollowed out to define a second hollowed-out region, the second signal line, the RF test pad, and the first coaxial-cable connector each are in the second shielding region, a projection of the second signal line on the fifth layer, a projection of the RF test pad on the fifth layer, and a projection of the first coaxial-cable connector on the fifth layer each fall into the second hollowed-out region, and the first circuit board defines in the second shield a plurality of second ground holes arranged at intervals.

9. The earphone of claim 7, wherein the RF test pad and the first coaxial-cable connector each are on the surface of the first layer away from the second layer, the RF test pad and the first coaxial-cable connector each are in the first shielding region, a projection of the RF test pad on the second layer and a projection of the first coaxial-cable connector on the second layer each fall into the first hollowed-out region.

10. The earphone of claim 5, wherein the second circuit board comprises a seventh layer, an eighth layer, and a ninth layer stacked in sequence, the second RF circuit comprises a third signal line, a third shield, and a third reference line, the third signal line, the third shield, the connecting member, and the second π filter each are on a surface of the seventh layer away from the eighth layer, the third reference line is on a surface of the ninth layer away from the eighth layer, a third shielding region is enclosed by the third shield, the third signal line, the second π filter, and the connecting member each are in the third shielding region, part of the eighth layer is hollowed out to define a third hollowed-out region, a projection of the third signal line on the eighth layer, a projection of the connecting member on the eighth layer, and a projection of the second π filter on the eighth layer each fall into the third hollowed-out region, and the second circuit board defines in the third shield a plurality of third ground holes arranged at intervals.

11. The earphone of claim 10, wherein the second circuit board comprises a tenth layer, an eleventh layer, and a twelfth layer stacked in sequence, the tenth layer is on the surface of the ninth layer away from the eighth layer, the second RF circuit comprises a fourth signal line, a fourth shield, and a fourth reference line, part of the eleventh layer is hollowed out to define a fourth hollowed-out region, the fourth signal line, the fourth shield, and the second coaxial-cable connector each are on a surface of the twelfth layer away from the eleventh layer, the fourth reference line is on a surface of the tenth layer away from the eleventh layer, a fourth shielding region is enclosed by the fourth shield, the fourth signal line and the second coaxial-cable connector each are in the fourth shielding region, a projection of the fourth signal line on the eleventh layer and a projection of the second coaxial-cable connector on the eleventh layer each fall into the fourth hollowed-out region, and the second circuit board defines in the fourth shield a plurality of fourth ground holes arranged at intervals.

12. The earphone of claim 10, wherein the second coaxial-cable connector is on the surface of the seventh layer away from the eighth layer, the second coaxial-cable connector is in the third shielding region, and a projection of the second coaxial-cable connector on the eighth layer falls into the third hollowed-out region.

13. The earphone of any of claims 1 to 12, wherein the connecting member is a spring lamination or a spring needle, and the antenna is configured to abut against the connecting member at part of a surface of the antenna facing the connecting member; and/or
the RF transceiver is a Bluetooth transceiver; and/or
the RF transceiver is integrated on a system on a chip (SoC), and the SoC is on the first circuit board.
